# EUROPEAN PATENT SPECIFICATION

(11) **EP 2 418 706 B1**
(45) Date of publication and mention of the grant of the patent: **02.10.2013**
(21) Application number: 10172560.4
(22) Date of filing: 11.08.2010
(51) Int. Cl.: H01L 41/053, G06F 3/01

(54) **Actuator assembly and electronic device including same**
Aktoranordnung und diese umfassende elektronische Vorrichtung
Ensemble d'actionneur et dispositif électronique l'incluant

(43) Date of publication of application: 15.02.2012
(73) Proprietor: BlackBerry Limited, Waterloo ON N2L 3W8 (CA)
(72) Inventor: Dehmoubed, Farzin, Waterloo, Ontario N2L 3W8 (CA); Welker, Michael, Waterloo, Ontario N2L 3W8 (CA)
(74) Representative: MERH-IP Matias Erny Reichl Hoffmann

(56) References cited:
- US-A1- 2006 138 903
- US-A1- 2007 097 073
- US-A1- 2008 100 177
- US-A1- 2010 156 843

## Description

### FIELD OF TECHNOLOGY

The present disclosure relates to an actuator assembly for providing tactile feedback in an electronic device that includes a touch-sensitive input device.

### BACKGROUND

Electronic devices, including portable electronic devices, have gained widespread use and may provide a variety of functions including, for example, telephonic, electronic text messaging and other personal information manager (PIM) application functions. Portable electronic devices can include several types of devices including mobile stations such as simple cellular phones, smart phones, Personal Digital Assistants (PDAs), and laptop computers.

Devices such as PDAs or smart phones are generally intended for handheld use and ease of portability. Smaller devices are generally desirable for portability. Touch-sensitive devices constructed of a display, such as a liquid crystal display (LCD), with a touch-sensitive overlay are useful on such handheld devices as such handheld devices are small and are therefore limited in space available for user input and output devices. Further, the screen content on the touch-sensitive devices can be modified depending on the functions and operations being performed.

Tactile feedback for such touch-sensitive input devices provides a positive confirmation of, for example, touch selection. The provision and control of tactile feedback in touch-sensitive devices is desirable.

US 2010/156843 A1 discloses an actuator assembly, wherein piezoelectric unimorph actuators are supported on a flat base. Force sensors are arranged between the actuators and an overlying display unit.

US 2007/97073 A1 teaches an assembly comprising piezoelectric bending actuators built into the side faces of a rectangular chassis frame which also carries force sensors at the corners of its surface.

### SUMMARY

An actuator assembly, for use in an electronic device, includes a support tray, an actuator supported on the support tray, a force sensor spaced laterally from the actuator, and a cover covering the actuator and coupled to the support tray. A portion of the cover is movable relative to the support tray when the actuator is actuated.

An electronic device includes a housing, a touch-sensitive input device exposed by the housing, and an actuator assembly. The actuator assembly is housed in the housing and coupled to the touch-sensitive input device.

### BRIEF DESCRIPTION OF THE DRAWINGS

Embodiments of the present disclosure will now be described, by way of example only, with reference to the attached Figures, wherein:

FIG. 1 is a simplified block diagram of components including internal components of a portable electronic device according to an example embodiment;

FIG. 2 is a perspective view of an example of a portable electronic device;

FIG. 3 is an exploded view of portions of the portable electronic device of FIG. 2, including an actuator assembly in accordance with an example embodiment;

FIG. 4 is an exploded view of the actuator assembly of FIG. 3;

FIG. 5 is a further exploded view of the actuator assembly of FIG. 3;

FIG. 6 is a perspective view of the actuator assembly of FIG. 3; and

FIG. 7 is another perspective view of the actuator assembly of FIG. 3.

### DETAILED DESCRIPTION

The following describes an actuator assembly for use in an electronic device. The actuator assembly includes a support tray, an actuator supported on the support tray, a force sensor spaced laterally from the actuator, and a cover covering the actuator and coupled to the support tray. A portion of the cover is movable relative to the support tray when the actuator is actuated.

It will be appreciated that for simplicity and clarity of illustration, where considered appropriate, reference numerals may be repeated among the figures to indicate corresponding or analogous elements. In addition, numerous specific details are set forth in order to provide a thorough understanding of the example embodiments described herein. However, it will be understood by those of ordinary skill in the art that the example embodiments described herein may be practiced without these specific details. In other instances, well-known methods, procedures and components have not been described in detail so as not to obscure the example embodiments described herein. Also, the description is not to be considered as limited to the scope of the example embodiments described herein.

The actuator assembly provides a relatively thin device to provide desirable tactile feedback, for example, to simulate actuation of a dome switch upon touching or upon application of an external force to the touch-sensitive display, confirming receipt of input to the user. The tactile feedback provides a positive response and reduces the chance of input errors such as double entry, decreasing use time and increasing user-satisfaction. The actuator assembly includes a metal actuator sheet that facilitates grounding of the touch-sensitive display that is disposed on the actuator sheet. The actuator sheet facilitates pre-loading of the actuator assembly during production of the actuator assembly. The tolerance of the actuator assembly may be controlled to a tight tolerance at a lower cost by comparison to ensuring very tight tolerances for all individual parts. The force sensors are laterally spaced from the actuators in the support tray such that a preload on the force sensors, which is the load on the force sensors absent an external applied force by a user pressing on the touch-sensitive display, may differ from a preload on the actuators. Thus, the preload on the force sensors and the actuators may be separately controlled.

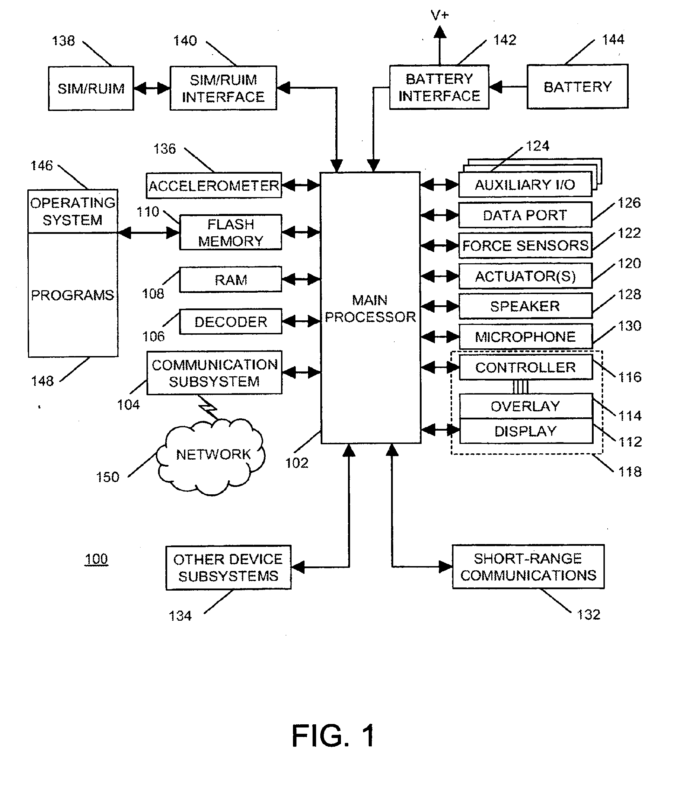

Example embodiments of the actuator assembly described herein are utilized in an electronic device such as a portable electronic device that includes a touch-sensitive display. FIG. 1 shows a simplified block diagram of components including internal components of a portable electronic device according to an example embodiment.

The portable electronic device 100 includes multiple components such as a processor 102 that controls the operations of the portable electronic device 100. Communication functions, including data and voice communications, are performed through a communication subsystem 104. Data received by the portable electronic device 100 is decompressed and decrypted by a decoder 106. The communication subsystem 104 receives messages from and sends messages to a wireless network 150. The wireless network 150 may be any type of wireless network, including, but not limited to, data-centric wireless networks, voice-centric wireless networks, and dual-mode networks that support both voice and data communications over the same physical base stations. The portable electronic device 100 is a battery-powered device and includes a battery interface 142 for receiving one or more rechargeable batteries 144.

The processor 102 also interacts with additional subsystems such as a Random Access Memory (RAM) 108, a flash memory 110, a display 112 with a touch-sensitive overlay 114 connected to an electronic controller 116 that together comprise a touch-sensitive display 118, actuators 120, force sensors 122, an auxiliary input/output (I/O) subsystem 124, a data port 126, a speaker 128, a microphone 130, short-range communications 132 and other device subsystems 134. User-interaction with the graphical user interface is performed through the touch-sensitive overlay 114. The processor 102 interacts with the touch-sensitive overlay 114 via the electronic controller 116. Information, such as text, characters, symbols, images, icons, and other items that may be displayed or rendered on a portable electronic device, is displayed on the touch-sensitive display 118 via the processor 102. The processor 102 may also interact with an accelerometer 136 as shown in FIG. 1. The accelerometer 136 may include a cantilever beam with a proof mass and suitable deflection sensing circuitry. The accelerometer 136 may be utilized for detecting direction of gravitational forces or gravity-induced reaction forces.

To identify a subscriber for network access according to the present embodiment, the portable electronic device 100 uses a Subscriber Identity Module or a Removable User Identity Module (SIM/RUIM) card 138 inserted into a SIM/RUIM interface 140 for communication with a network such as the wireless network 150. Alternatively, user identification information may be programmed into the flash memory 110.

The portable electronic device 100 also includes an operating system 146 and software components 148 that are executed by the processor 102 and are typically stored in a persistent store such as the flash memory 110. Additional applications may be loaded onto the portable electronic device 100 through the wireless network 150, the auxiliary I/O subsystem 124, the data port 126, the short-range communications subsystem 132, or any other suitable device subsystem 134.

In use, a received signal such as a text message, an e-mail message, or web page download is processed by the communication subsystem 104 and input to the processor 102. The processor 102 then processes the received signal for output to the display 112 or alternatively to the auxiliary I/O subsystem 124. A subscriber may also compose data items, such as e-mail messages, for example, which may be transmitted over the wireless network 150 through the communication subsystem 104. For voice communications, the overall operation of the portable electronic device 100 is similar. The speaker 128 outputs audible information converted from electrical signals, and the microphone 130 converts audible information into electrical signals for processing.

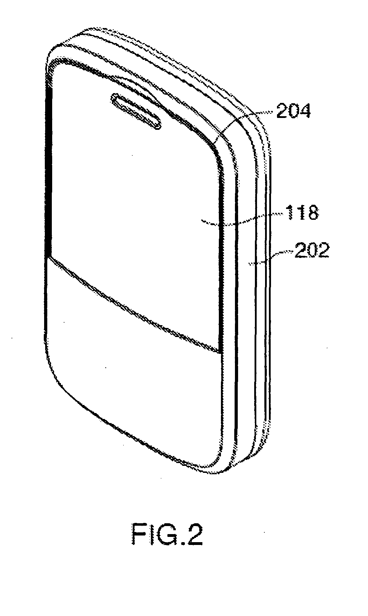

FIG. 2 is a perspective view of an example of a portable electronic device 100. The portable electronic device 100 includes a housing 202 that is suitable for housing the internal components shown in FIG. 1. The housing includes a frame 204 that frames the touch-sensitive display 118 for user-interaction with the touch-sensitive display 118. Although not shown in the figures, the portable electronic device 100 of FIG. 2 may also include a physical keyboard (not shown) such that the processor 102 (shown in FIG. 1) interacts with the keyboard and the housing 202 is constructed to accommodate the keys of the keyboard.

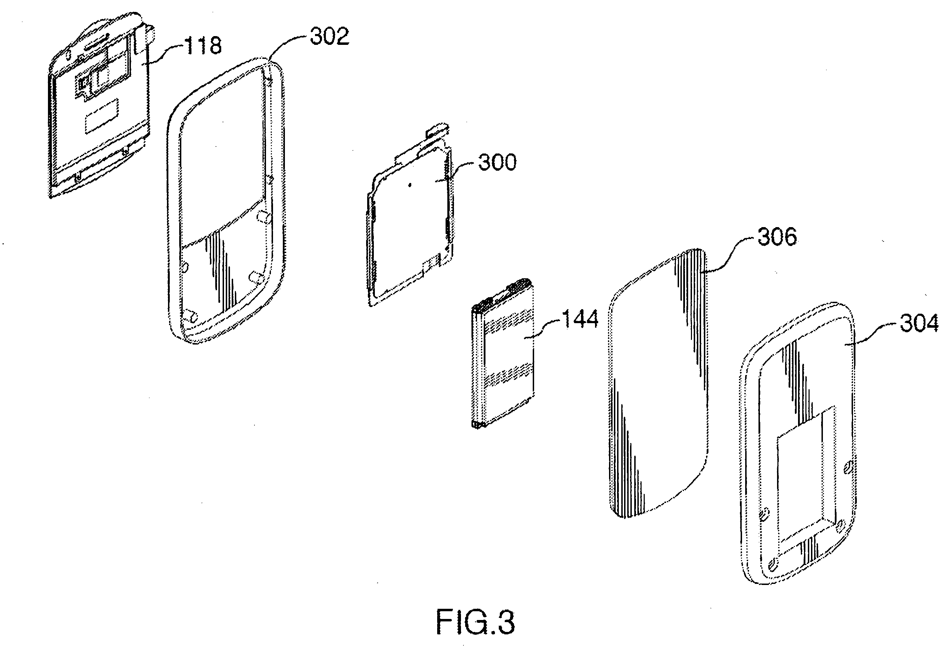

FIG. 3 is an exploded view of portions of the portable electronic device 100 including an actuator assembly 300. The housing 202, shown in FIG. 2,of the portable electronic device 100 includes a front 302, that includes the frame 204, and the back 304. The back 304 of the housing 202 includes an opening that may be covered by a plate that is releasably attachable to the back 304 for insertion and removal of, for example, the SIM/RUIM card 138 shown in FIG. 1. In the example of FIG. 3, the battery 144 is shown along with a printed circuit board 306. The touch-sensitive display 118 is disposed on the actuator assembly 300 and is available for user interaction through an opening, defined the by frame 204, in the front 302 of the housing 204.

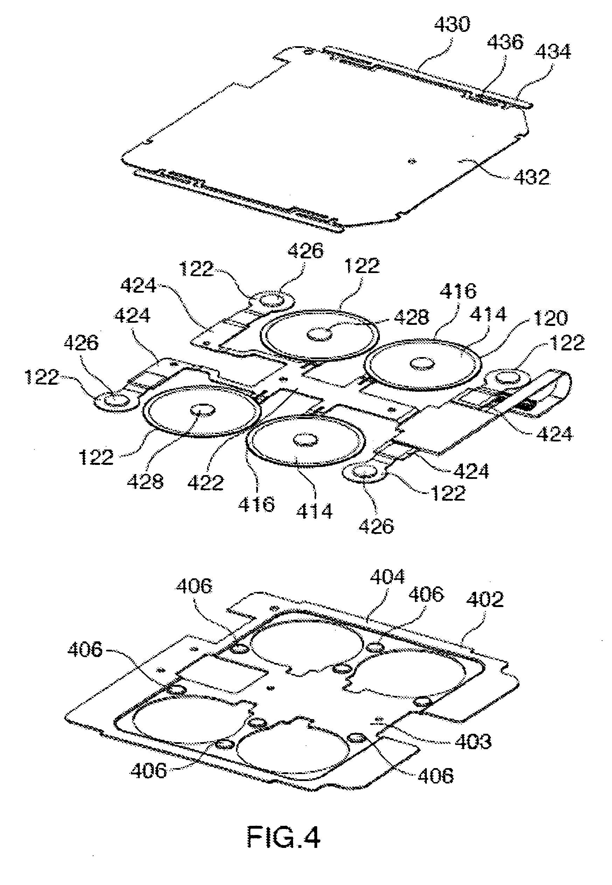

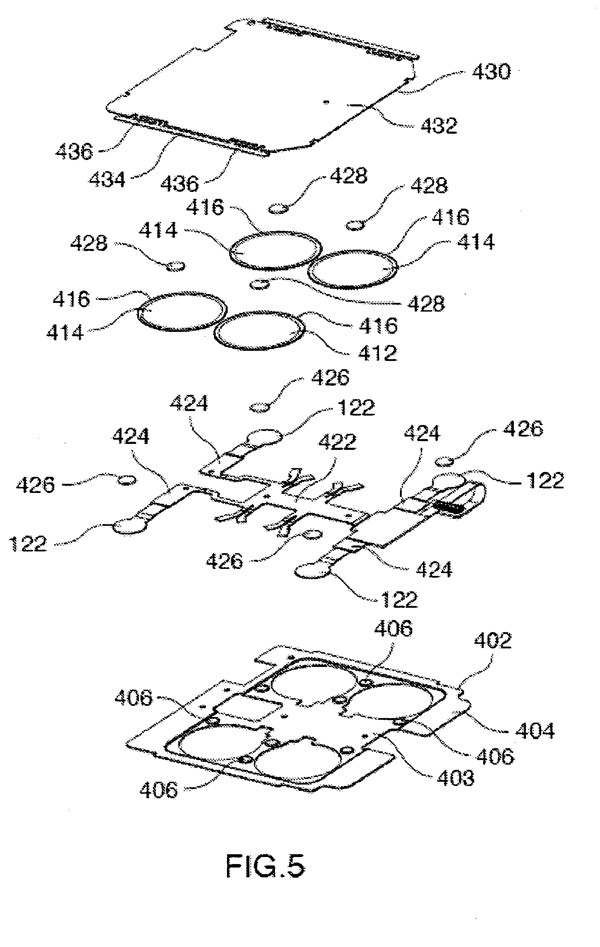

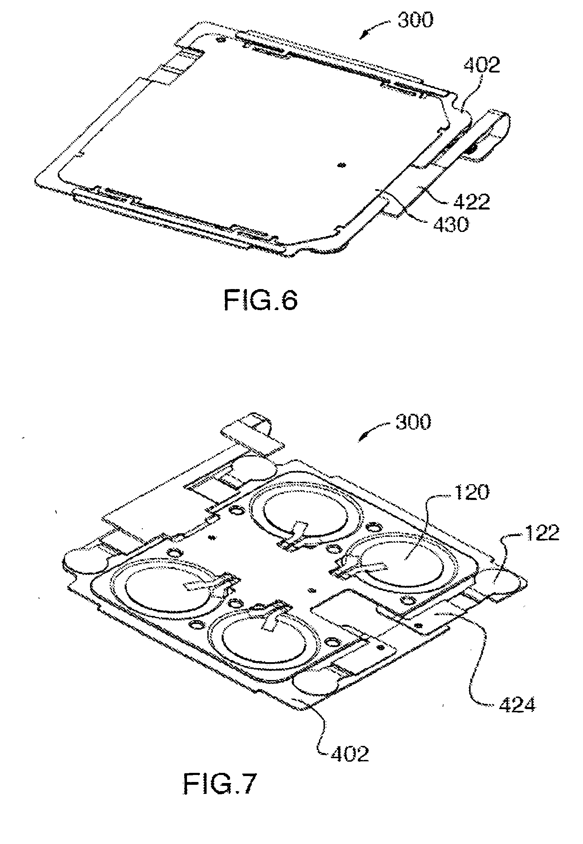

Referring now to FIG. 4 through FIG. 7, various views of the actuator assembly 300 are shown. The actuator assembly 300 includes, for example, four actuators 120, which in the present embodiment are piezoelectric disk actuators. Different numbers of actuators 120 may be utilized in other embodiments. The actuators 120 are supported by a support tray 402 that is generally rectangular in shape. The support tray 402 includes a base 403 with a lip 404 that protrudes from one side of the base 403 and extends generally around the base 403. The lip 404 extends only partly around the base 403 as a break in the lip 404 is provided for connection of a flexible printed circuit board to two force sensors 122 near one end of the support tray 402, as described below. A cut-out portion in the support tray 402 is utilized for connection of the flexible printed circuit board to two additional force sensors 122 near an opposing end of the support tray 402.

Four apertures, that are generally circular, extend through the support tray 402. Each aperture is located near a respective corner of the base 403. The apertures correspond with the locations of the actuators 120, referred to below. The apertures include an additional cut-away tab for connection to the flexible printed circuit board. A margin of the base 403 around each of the four apertures provides a seat for the respective actuator 120.

In addition to the apertures, stops 406 are formed in the support tray 402. The stops 406 project from the base 403, protruding in the same direction that the lip protrudes. In the present example, the stops 406 are generally cylindrical and are adjacent the four apertures that provide seats for the actuators. Eight stops 406 are utilized to limit bending forces on the actuators 120, caused by an external applied force on the touch-sensitive display 118.

The support tray 402 may be formed of metal such as stainless steel. Additional holes in the support tray 402 are provided for alignment with holes in other components of the actuator assembly 300.

A non-conductive tape (not shown) is disposed on the support tray 402 and adhered to the support tray 402 and the actuators 120 to electrically isolate the actuators 120 from the support tray 402. The non-conductive tape may cover the entire support tray 402.

Each actuator 120 includes a piezoelectric disk such as a PZT ceramic disk 414 adhered to a metal substrate 416 of larger diameter than the piezoelectric disk 414 for bending when the piezoelectric disk 414 contracts diametrically as a result of build up of charge at the piezoelectric disk 414. The metal substrate 416 of the actuator 120 is supported on the margin of the base 403 around each of the four apertures. The non-conductive tape electrically isolates the metal substrate 416 and the piezoelectric disk 414 from the support tray 402.

Conductive tape may be utilized to adhere each piezoelectric disk 414 of each actuator 120 to a flexible printed circuit board 422. The flexible printed circuit board 422 includes conductive traces that are electrically connected to the piezoelectric disks 414 to connect the actuators 120 to, for example, the printed circuit board 306 of the portable electronic device 100. The flexible printed circuit board 422 also includes legs 424 that extend to an opposing side of the support tray 402 through the break in the lip 404 near one end of the support tray 402 and through the cut-out portion near the opposing end of the support tray 402. Each of four force sensors 122 is connected to a respective leg 424 of the flexible printed circuit board 422. In the present example, the force sensors 122 comprise force-sensing resistors and are attached to a backside of the lip 404 of the support tray 402 by resilient plungers 426 that are disposed between the force sensors 122 and the support tray 402. The force sensors 122 are attached, via the plungers 426 to a backside of the lip 404 of the support tray 402 by a non-conductive adhesive such that the actuators 120 are disposed on one side of the support tray 402 and the force sensors 122 are laterally spaced from the force sensors 122 and are disposed on an opposite side of the support tray 402. The plungers 426 are resilient plungers of, for example, silicone. Four additional plungers 428 are disposed on the actuators 120, with a respective plunger 428 on each actuator 120. The additional plungers 428 are also resilient and may be, for example, silicone. The force sensors 122 may be preloaded, between the actuator assembly 300 and a base or other support within the housing 202 that provides a base for the actuator assembly 300, to thereby control the preload on the force sensors 122 separate of the preload on the actuators 120.

Still referring to FIG. 4 through FIG. 7, an actuator sheet 430 covers a portion of the flexible printed circuit board 422 and the actuators 120 and is coupled to the support tray 402. The actuator sheet 430 includes a generally rectangular inner sheet 432 with two side rails 434 on opposite sides of the inner sheet 432. The inner sheet 432 is spaced from each side rail 434 by a respective intermediate gap. Each intermediate gap is interrupted by resiliently flexible arms 436 that join the inner sheet 432 to the side rails 434. The arms 436 form a jog, such that the location at which each of the arms 436 joins the inner sheet 432 is offset from alignment with the location that the arm 436 joins one of the side rails 434, to facilitate movement of the inner sheet 432 relative to the side rails 434. The inner sheet 432, side rails 434 and resiliently flexible arms 436 may be integral portions of a sheet.

The inner sheet 432 includes alignment holes for aligning the actuator sheet 430 with the support tray 402. In the present example, the actuator sheet 430 is a metal sheet of, for example, spring steel to facilitate grounding of the touch-sensitive display 118 that is disposed on the actuator sheet 430. The side rails 434 are coupled to the support tray 402 by, for example, spot welding the side rails 434 to the lip 404 of the support tray 402. Alternatively, the actuator sheet 430 may form a mechanical interlock with the support tray 402. The inner sheet 432 is movable relative to the side rails 434 and the support tray 402 for moving the touch-sensitive display when the actuators 120 are actuated. The actuator sheet 430 facilitates pre-loading of the actuators 120 during production of the actuator assembly 300 such that a bending force acts on the actuators 120, and the actuators 120 provide a spring force in return, when the actuators 120 are not charged and the actuator assembly 300 is in a rest position.

The touch-sensitive display 118 is an assembly of components including the LCD display 112, the overlay 114 and controller 116 (shown in FIG. 1). The touch-sensitive display 118 may be a capacitive touch-sensitive display, for example, and a user's touch on the touch-sensitive display may be determined by determining the X and Y location of the touch with the X location determined by a signal generated as a result of capacitive coupling with a touch sensor layer and the Y location determined by the signal generated as a result of capacitive coupling with another touch sensor layer. Each of the touch-sensor layers provides a signal to the controller 116 that represents the respective X and Y touch location values. Thus a feature such as a virtual button or other feature displayed on the touch-sensitive display 118 may be selected by a mapping of the touch location to a feature on the touch-sensitive display 118.

The touch-sensitive display 118 is coupled to the inner sheet 432. The actuator assembly 300 acts on the touch-sensitive display 118 such that when the actuators 120 are actuated, a force is transmitted from the actuators 120, through the actuator sheet 430 and to the touch-sensitive display 118, to move the touch-sensitive display 118 relative to the back 304 of the housing 202 of the portable electronic device 100.

A charge applied to the piezoelectric disks 414 of the actuators 120 results in the piezoelectric disk 414 shrinking diametrically, causing the metal substrate 416 and therefore the entire actuator 120, to bend and apply a force to the inner sheet 432 of the actuator sheet 430. Because the inner sheet 432 is moveable relative to the support tray 402, the inner sheet 432 may be moved away from the support tray 402 as the resiliently flexible arms 436 are flexed. The touch-sensitive display 118 may be moved away from the support tray 402, and thus, away from the back 304 of the housing 202 of the portable electronic device 100. The removal of the charge, causes the actuators 120 to return to the rest position and the resiliently flexible arms 436 facilitate movement of the inner sheet 432 to return to the rest position. Thus, the touch-sensitive display 118 is moved back to the rest position. The actuators 120 are connected through the flexible printed circuit board 422 to, for example, the printed circuit board of the portable electronic device 100 and may be controlled by drive circuitry connected to the processor 102 or other microprocessor.

The force sensors 122 are utilized to determine a value related to an applied force by a user touch on the touch-sensitive display 118 as a force applied to the touch-sensitive display 118 is translated to the force sensors 122. The actuators 120 may be controlled to provide movement of the touch-sensitive display 118 in response to detection of an applied force, on the touch-sensitive display 118, that meets or exceeds a force threshold.

The mechanical work performed by the actuators 120 may be controlled to control the force and movement of the touch-sensitive display 118. Fluctuations in mechanical work performed as a result of, for example, temperature, may be reduced by modulating the current to the actuators 120 to control the charge. An increase in the charge increases the force on the touch-sensitive display 118 away from the support tray 402 and a decrease in the charge decreases the force on the touch-sensitive display 118, facilitating movement of the touch-sensitive display 118 toward the base 403. In the present example embodiment, each of the actuators 120 is controlled equally and concurrently. It will be appreciated that the piezoelectric actuators may be controlled separately, however. The portable electronic device 100 is controlled generally by modulating a force on the touch-sensitive display 118 in response to detection of an applied force on the touch-sensitive display 118.

The embodiments shown and described herein illustrate examples only and many modifications may be made. For example, the number of actuators may differ. In one example, four actuators are located near respective corners of the actuator assembly.

The actuator assembly provides a relatively thin device to provide desirable tactile feedback, for example, to simulate actuation of a dome switch upon touching the touch-sensitive display, confirming receipt of input to the user. The tactile feedback provides a positive response and reduces the chance of input errors such as double entry, decreasing use time and increasing user-satisfaction. Further, the actuator assembly includes a metal actuator sheet that facilitates grounding of the touch-sensitive display that is disposed on the actuator sheet. The actuator sheet facilitates pre-loading of the actuator assembly during production of the actuator assembly. Furthermore, the tolerance of the actuator assembly may be controlled to provide an assembly with tight tolerance. The tolerance of the entire assembly may be controlled at a lower cost by comparison to controlling the tolerance for all the parts individually. The force sensors are laterally spaced from the actuators in the support tray such that a preload on the force sensors, which is the load on the force sensors absent an external applied force by a user pressing on the touch-sensitive display, may differ from a preload on the actuators. Thus, the preload on the force sensors and the actuators may be separately controlled.

While the embodiments described herein are directed to particular implementations of the actuating assembly and the portable electronic device, it will be understood that modifications and variations may occur to those skilled in the art. All such modifications and variations are believed to be within the scope of the present disclosure as defined by the claims.

## Claims

1. An actuator assembly (300) for use in an electronic device (100), the actuator assembly (300) comprising:
a support tray (402);
an actuator (120) supported on the support tray (402);
a force sensor (122) spaced laterally from the actuator (120);
a cover (430) covering the actuator (120) and coupled to the support tray (402), a portion (432) of the cover being movable relative to the support tray (402) when the actuator (120) is actuated.

2. The actuator assembly (300) according to claim 1, wherein the force sensor (122) comprises a plurality of force sensors (122) disposed on an opposite side of the support tray (402) relative to the actuator (120).

3. The actuator assembly (300) according to claim 2, wherein the force sensors (122) are disposed between the support tray (402) and a base (403).

4. The actuator assembly (300) according to any of claims 1 to 3, wherein the actuator (120) comprises a plurality of piezoelectric disk actuators.

5. The actuator assembly (300) according to claim 4 wherein the force sensor (122) comprises a plurality of force sensors (122), each of the force sensors (122) spaced laterally from each of the piezoelectric disk actuators.

6. The actuator assembly (300) according to claim 5, wherein the force sensors (122) are disposed on an opposite side of the support tray (402) relative to the piezoelectric disk actuators.

7. The actuator assembly (300) according to claim 4, wherein the support tray (402) includes openings in the support tray (402) at which the piezoelectric disk actuators are supported.

8. The actuator assembly (300) according to claim 4, comprising a plurality of resilient plungers (426, 428), wherein respective resilient plungers (426) are disposed between each force sensor (122) and the support tray (402).

9. The actuator assembly (300) according to claim 8, wherein respective resilient plungers (428) are disposed between each actuator (120) and the cover.

10. The actuator assembly (300) according to any of claims 1 to 9, comprising a printed circuit board (422), at least partially disposed between the support tray (402) and the cover.

11. The actuator assembly according to claim 10 wherein the printed circuit board (422) is connected to the actuator (120) to provide an electrical connection for controlling the actuator (120).

12. The actuator assembly (300) according to claim 10, wherein the printed circuit board (422) is connected to the force sensor (122) to provide an electrical connection thereto.

13. The actuator assembly (300) according to any of claims 1 to 12, wherein the cover (430) includes first and second portions connected by a flexible connection, the first portion (434) being coupled to the support tray (402) and the second portion (432) being the portion that is movable relative to the support tray (402).

14. The actuator assembly (300) according to claim 13, wherein the first portion comprises side rails (434), with a respective one of the side rails (434) on each side of the second portion (432) being connected to the second portion by spring arms (436).

15. The actuator assembly (300) according to claim 14, wherein the spring arms (436) comprises thin portions of metal connecting the first and second portions.

16. An electronic device (100) comprising:
a housing (202);
a touch-sensitive input device (118) exposed by the housing (202); and
an actuator assembly (300) according to any one of claims 1 to 15, the actuator assembly (300) housed in the housing (202) and coupled to the touch-sensitive input device (118).

## Patentansprüche

1. Aktuator-Baugruppe (300) zur Verwendung in einer elektronischen Vorrichtung (100), wobei die Aktuator-Baugruppe (300) aufweist:
eine Unterstützungsplatte (402);
einen Aktuator (120), der auf der Unterstützungsplatte (402) getragen wird;
einen Kraftsensor (122), der seitlich von dem Aktuator (120) beabstandet ist;
eine Abdeckung (430), die den Aktuator (120) abdeckt und mit der Unterstützungsplatte (402) gekoppelt ist, wobei ein Teil (432) der Abdeckung relativ zu der Unterstützungsplatte (402) bewegbar ist, wenn der Aktuator (120) betätigt wird.

2. Die Aktuator-Baugruppe (300) gemäß Anspruch 1, wobei der Kraftsensor (122) eine Vielzahl von Kraftsensoren (122) aufweist, die an einer gegenüberliegenden Seite der Unterstützungsplatte (402) relativ zu dem Aktuator (120) angeordnet sind.

3. Die Aktuator-Baugruppe (300) gemäß Anspruch 2, wobei die Kraftsensoren (122) zwischen der Unterstützungsplatte (402) und einer Basis (403) angeordnet sind.

4. Die Aktuator-Baugruppe (300) gemäß einem der Ansprüche 1 bis 3, wobei der Aktuator (120) eine Vielzahl von piezoelektrischen Scheiben-Aktuatoren aufweist.

5. Die Aktuator-Baugruppe (300) gemäß Anspruch 4, wobei der Kraftsensor (122) eine Vielzahl von Kraftsensoren (122) aufweist, wobei jeder der Kraftsensoren (122) von jedem der piezoelektrischen Scheiben-Aktuatoren seitlich beabstandet ist.

6. Die Aktuator-Baugruppe (300) gemäß Anspruch 5, wobei die Kraftsensoren (122) auf einer gegenüberliegenden Seite der Unterstützungsplatte (402) relativ zu den piezoelektrischen Scheiben-Aktuatoren angeordnet sind.

7. Die Aktuator-Baugruppe (300) gemäß Anspruch 4, wobei die Unterstützungsplatte (402) Öffnungen in der Unterstützungsplatte (402) umfasst, an denen die piezoelektrischen Scheiben-Aktuatoren getragen werden.

8. Die Aktuator-Baugruppe (300) gemäß Anspruch 4, die eine Vielzahl von elastischen Druckstücken (426, 428) aufweist, wobei jeweilige elastischen Druckstücke (426) zwischen jedem Kraftsensor (122) und der Unterstützungsplatte (402) angeordnet sind.

9. Die Aktuator-Baugruppe (300) gemäß Anspruch 8, wobei jeweilige elastische Druckstücke (428) zwischen jedem Aktuator (120) und der Abdeckung angeordnet sind.

10. Die Aktuator-Baugruppe (300) gemäß einem der Ansprüche 1 bis 9, die eine Leiterplatte (422) aufweist, die zumindest teilweise zwischen der Unterstützungsplatte (402) und der Abdeckung angeordnet ist.

11. Die Aktuator-Baugruppe gemäß Anspruch 10, wobei die Leiterplatte (422) mit dem Aktuator (120) verbunden ist, um eine elektrische Verbindung zur Steuerung des Aktuators (120) vorzusehen.

12. Die Aktuator-Baugruppe (300) gemäß Anspruch 10, wobei die Leiterplatte (422) mit dem Kraftsensor (122) verbunden ist, um eine elektrische Verbindung mit diesem vorzusehen.

13. Die Aktuator-Baugruppe (300) gemäß einem der Ansprüche 1 bis 12, wobei die Abdeckung (430) erste und zweite Teile umfasst, die durch eine flexible Verbindung verbunden sind, wobei der erste Teil (434) mit der Unterstützungsplatte (402) gekoppelt ist und der zweite Teil (432) der Teil ist, der relativ zu der Unterstützungsplatte (402) bewegbar ist.

14. Die Aktuator-Baugruppe (300) gemäß Anspruch 13, wobei der erste Teil Seitenschienen (434) aufweist, wobei eine jeweilige der Seitenschienen (434) auf jeder Seite des zweiten Teils (432) mit dem zweiten Teil durch Federarme (436) verbunden ist.

15. Die Aktuator-Baugruppe (300) gemäß Anspruch 14, wobei die Federarme (436) dünne Teile aus Metall aufweisen, die die ersten und zweiten Teile verbinden.

16. Eine elektronische Vorrichtung (100), die aufweist:
ein Gehäuse (202);
eine berührungsempfindliche Eingabevorrichtung (118), die durch das Gehäuse (202) exponiert wird; und
eine Aktuator-Baugruppe (300) gemäß einem der Ansprüche 1 bis 15, wobei die Aktuator-Baugruppe (300) dem Gehäuse (202) aufgenommen ist und mit der berührungsempfindlichen Eingabevorrichtung (118) verbunden ist.

## Revendications

1. Ensemble d'actionneur (300) pour utilisation dans un dispositif électronique (100), l'ensemble d'actionneur (300) comprenant :
un plateau de support (402) ;
un actionneur (120) supporté sur le plateau de support (402) ;
un capteur de force (122) latéralement espacé de l'actionneur (402) ;
un couvercle (430) couvrant l'actionneur (120) et couplé au plateau de support (402), une partie (432) du couvercle étant mobile par rapport au plateau de support (402) lorsque l'actionneur (120) est actionné.

2. Ensemble d'actionneur (300) selon la revendication 1, dans lequel le capteur de force (122) comprend une pluralité de capteurs de force (122) disposés sur un côté opposé du plateau de support (402) par rapport à l'actionneur (120).

3. Ensemble d'actionneur (300) selon la revendication 2, dans lequel les capteurs de force (122) sont disposés entre le plateau de support (402) et une base (403).

4. Ensemble d'actionneur (300) selon l'une quelconque des revendications 1 à 3, dans lequel l'actionneur (120) comprend une pluralité d'actionneurs à disque piézoélectrique.

5. Ensemble d'actionneur (300) selon la revendication 4, dans lequel le capteur de force (122) comprend une pluralité de capteurs de force (122), chacun des capteurs de force (122) étant latéralement espacés de chacun des actionneurs à disque piézoélectrique.

6. Ensemble d'actionneur (300) selon la revendication 5, dans lequel les capteurs de force (122) sont disposés sur un côté opposé du plateau de support (402) par rapport aux actionneurs à disque piézoélectrique.

7. Ensemble d'actionneur (300) selon la revendication 4, dans lequel le plateau de support (402) comprend des ouvertures dans le plateau de support (402), au niveau desquelles sont supportés les actionneurs à disque piézoélectrique.

8. Ensemble d'actionneur (300) selon la revendication 4, comprenant une pluralité de plongeurs élastiques (426, 428), dans lequel des plongeurs élastiques respectifs (426) sont disposés entre chaque capteur de force (122) et le plateau de support (402).

9. Ensemble d'actionneur (300) selon la revendication 8, dans lequel des plongeurs élastiques respectifs (428) sont disposés entre chaque actionneur (120) et le couvercle.

10. Ensemble d'actionneur (300) selon l'une quelconque des revendications 1 à 9, comprenant une carte de circuits imprimés (422), disposée au moins partiellement entre le plateau de support (402) et le couvercle.

11. Ensemble d'actionneur selon la revendication 10, dans lequel la carte de circuits imprimés (422) est connectée à l'actionneur (120) de façon à fournir une connexion électrique pour commander l'actionneur (120).

12. Ensemble d'actionneur (300) selon la revendication 10, dans lequel la carte de circuits imprimés (422) est connectée au capteur de force (122) de façon à fournir une connexion électrique entre ceux-ci.

13. Ensemble d'actionneur (300) selon l'une quelconque des revendications 1 à 12, dans lequel le couvercle (430) comprend des première et deuxième parties reliées par une liaison souple, la première partie (434) étant couplée au plateau de support (402) et la deuxième partie (432) étant la partie qui est mobile par rapport au plateau de support (402).

14. Ensemble d'actionneur (300) selon la revendication 13, dans lequel la première partie comprend des rails latéraux (434), un rail respectif des rails latéraux (434) de chaque côté de la deuxième partie (432) étant relié à la deuxième partie par des bras de ressort (436).

15. Ensemble d'actionneur (300) selon la revendication 14, dans lequel les bras de ressort (436) comprennent des parties minces de métal reliant les première et deuxième parties.

16. Dispositif électronique (100), comprenant :
un boîtier (202) ;
un dispositif d'entrée tactile (118) exposé par le boîtier (202) ; et
un ensemble d'actionneur (300) selon l'une quelconque des revendications 1 à 15, l'ensemble d'actionneur (300) étant logé dans le boîtier (202) et couplé au dispositif d'entrée tactile (118).
